# EUROPÄISCHE PATENTSCHRIFT

(11) **EP 0 823 195 B1**
(45) Veröffentlichungstag und Bekanntmachung des Hinweises auf die Patenterteilung: **25.11.1998**
(21) Anmeldenummer: 96910965.1
(22) Anmeldetag: 15.04.1996
(51) Int. Cl.: H05K 7/20

(54) **GEHÄUSEAUFBAU FÜR IM FREIEN AUFSTELLBARE, ELEKTRISCHE UND/ODER ELEKTRONISCHE GERÄTE**
HOUSING STRUCTURE FOR ELECTRICAL AND/OR ELECTRONIC DEVICES FOR OUTDOOR INSTALLATION
STRUCTURE DE BOITIER POUR DISPOSITIFS ELECTRIQUES ET/OU ELECTRONIQUES A INSTALLER EN PLEIN AIR

(30) Priorität: 25.04.1995 DE 19515121
(43) Veröffentlichungstag der Anmeldung: 11.02.1998
(73) Patentinhaber: Rittal-Werk Rudolf Loh GmbH & Co. KG, 35745 Herborn (DE)
(72) Erfinder: WOLF, Kurt, W., D-75323 Bad Wildbad (DE)
(74) Vertreter: Fleck, Hermann-Josef, Dr.-Ing.
(86) Internationale Anmeldenummer: EP9601574
(87) Internationale Veröffentlichungsnummer: WO9634519

(56) Entgegenhaltungen:
- EP-A- 0 103 412
- DE-A- 2 813 682
- DE-A- 2 844 672
- FR-A- 1 085 779
- US-A- 4 840 225

## Beschreibung

Die Erfindung betrifft einen Gehäuseaufbau für im Freien aufstellbare elektrische und/oder elektronische Geräte.

Bei im Freien aufstellbaren, elektrischen und/oder elektronischen Geräten kommt es entscheidend auf die in der Atmosphäre herrschenden Bedingungen, wie Maximaltemperatur, Sandstürme, Regen und Sonneneinstrahlung und dgl. an. Es sei nur an den Einsatz von Fernseh-Sendeeinrichtungen und Fernseh-Empfangseinrichtungen in wüstenähnlichen Gebieten hingewiesen, wobei hohe Außentemperaturen auftreten können, bei denen der Betrieb der Einrichtungen gewährleistet sein muß. Da vielfach Leistungshalbleiter zum Einsatz kommen, stellt ihre Kühlung und ihre damit verbundene Betriebssicherheit ein wesentliches Kriterium für die Betriebssicherheit des Gerätes dar.

Die FR-A 1 085 779 offenbart einen abgedichteten Geräteschrank mit Schubkasten, die elektrische Schaltungen enthalten. Der Schrank weist eine Kühlanordnung auf, die aus einem Rohrbündel besteht. Die Rohre sind mit Umgebungsluft durchströmt und erlauben die Kühlung der Luft, die sich im Innenraum des Geräteschrankes befindet und zwischen die Rohre strömt. Der Aufbau weist jedoch keinen Außenschrank auf.

In der DE-A 28 13 682 ist ein Gerätekasten zur Aufnahme elektronischer Schaltungen mit integriertem Wärmetauscher angegeben. Die Wärmetauscherrohre sind zwischen innerem und äußerem Gehäusemantel angebracht.

Es ist Aufgabe der Erfindung, einen Gehäuseaufbau für im Freien aufstellbare, elektrische und/oder elektronische Geräte zu schaffen, der bei extremen Umweltbedingungen, was Temperatur und Schutz gegen Staub und Wasser betrifft, verwendet werden kann.

Diese Aufgabe wird nach der Erfindung dadurch gelöst, daß die elektrischen und/oder elektronischen Bauteile des Gerätes in einem staub- und spritzwasserdicht verschließbaren Innenschrank untergebracht sind, der vorzugsweise allseitig beabstandet in einen spritzwasserdicht verschließbaren Außenschrank eingebaut ist, daß im Innenschrank ein Luftwärmetauscher eingesetzt ist, dessen Eingangskreis über Umwälz-Ventilatoren die im Innenschrank auftretende Warmluft zuführbar ist und dessen Aufgangskreis mit dem Innenraum des Außenschrankes gekoppelt ist, und daß der Außenschrank zur Kühlung des Innenschrankes von einem gesteuerten Kühl-Luftstrom durchströmt ist, von dem ein Teil den Ausgangskreis des Luftwärmetauschers passiert.

Bei dieser Ausgestaltung sind die elektrischen und/oder elektronischen Bauteile staub- und spritzwassergeschützt untergebracht, wobei über den inneren Umwälzkreis des Innenschrankes mit dem Luftwärmetauscher die im Innenschrank erzeugte Wärme aus dem Innenschrank abgeführt und über den gesteuerten Kühl-Luftstrom des Außenschrankes ins Freie gelangt. Im Kühl-Luftstrom enthaltener Staub gelangt nicht in den Innenschrank, da dieser selbst staub- und spritzwasserdicht verschließbar ist, und der Ausgangskreis des Luftwärmetauschers vom Innenraum des Innenschrankes staubdicht entkoppelt ist.

Für den Innen- (lP66) und den Außenschrank (IP44) lassen sich entsprechend staub- und spritzwassergeschützte bzw. spritzwassergeschützte Schaltschränke mit aufeinander abgestimmten Abmessungen verwenden.

Nach einer Ausgestaltung ist vorgesehen, daß der Luftwärmetauscher als Rohrbündel ausgebildet ist, bei dem die Rohreingänge und -ausgänge mit korrespondierenden Öffnungen in der unteren und oberen Seitenwand des Innenschrankes zur Deckung gebracht oder bringbar sind. Die Außenoberfläche der Rohre des Rohrbündels bildet die Eingangsseite des Luftwärmetauschers, die bei mehreren dünnwandigen Rohren im Rohrbündel sehr groß gewählt werden kann. Die von den Rohren umschlossenen Innenquerschnitte bilden den davon eindeutig entkoppelten Ausgangskreis des Luftwärmetauschers.

Ist nach einer weiteren Ausgestaltung vorgesehen, daß der Luftwärmetauscher als getrennte Einheit in den Innenschrank einsetzbar ist, dann kann der Luftwärmetauscher als getrennte Einheit gefertigt und bei Bedarf in den Innenschrank eingesetzt werden.

Die Wirkung des Luftwärmetauschers im Innenschrank kann nach einer Ausgestaltung dadurch verbessert werden, daß dem Luftwärmetauscher in dem der unteren Seitenwand zugekehrten Bereich mittels eines ersten Umwälzventilators die Warmluft des Innenschrankes zuführbar und mittels eines zweiten Umwälzventilators in dem der oberen Seitenwand des Innenschrankes zugekehrten Bereich wieder aus dem Luftwärmetauscher absaugbar ist, wobei für den Umwälzkreis zudem vorgesehen ist, daß der untere und der obere Bereich des Luftwärmetauschers durch ein Trennblech abgeteilt sind.

Die Herstellung und der Einsatz der Umwälzventilatoren wird dadurch vereinfacht, daß die Umwälzventilatoren auf einer Trägerplatte befestigt sind, die parallel zum Luftwärmetauscher in den Innenschrank einsetzbar ist.

Zur besseren Ausnützung der Kühlwirkung von Kühlkörpern oder dgl. ist vorgesehen, daß bei auf Kühlkörpern oder dgl. aufgebauten, elektronischen Bauteilen die Kühlkörper auf der Außenseite der Seitenwände des Innenschrankes befestigt sind und über Durchbrüche mit dem Innenraum des Innenschrankes in Verbindung stehen. Die Befestigungsfläche der Kühlkörper und dgl. für die zu kühlenden elektronischen Bauteile bleibt im Innenschrank zugänglich. Damit die Wärme über die Kühlkörper und dgl. möglichst vollständig in den gekühlten Ziwschenraum zwischen Außen- und Innenschrank gelangt, sieht eine weitere Ausgestaltung vor, daß die im Innenraum des Innenschrankes mit den Kühlkörpern oder dgl. in Kontakt stehenden, elektronischen Bauteile zum Innenraum des Innenschrankes hin mittels einer wärmeisolierenden Abdeckung abgedeckt sind. Dadurch ist die Abstrahlung von Wärme in den Innenraum des Innenschrankes sehr stark reduziert, wenn nicht gar praktisch verhindert. Durch den Luftwärmetauscher und den inneren Umwälzkreis wird die Luft aus dem Innenschrank nach außen abgeführt.

Eine weitere Verbesserung zur Stabilisierung der Temperatur im Innenschrank auf möglichst niedrigem Temperaturniveau ist vorgesehen, daß die Außen- und Innenoberflächen vom Innenschrank mit einem Belag oder Anstrich versehen sind, der gute Wärmeabgabeeigenschaften aufweist, z.B. schwarz gestrichen ist.

Zur Erzeugung des Kühl-Luftstromes ist nach einer Ausgestaltung vorgesehen, daß der Kühl-Luftstrom von einem in die untere Seitenwand des Außenschrankes eingebauten staub- und spritzwassergeschützten Kühlluft-Ventilator (IP66) erzeugt wird, der die Luft aus dem Freien ansaugt und dem Innenraum des Außenschrankes zuführt, und daß der erwärmte Kühl-Luftstrom über Austrittsöffnungen in der oberen Seitenwand aus dem Außenschrank austritt.

Damit sich die Ansaugöffnung des Kühlluft-Ventilators nicht durch Blätter und dgl. zusetzen kann, sieht eine Weiterbildung vor, daß der Kühlluft-Ventilator zeitabhängig oder temperaturabhängig in der Drehrichtung kurzzeitig umschaltbar ist und den Luftstrom durch den Außenschrank umkehrt (Reservebetrieb).

Durch die Umkehr des Luftstromes läßt sich die Eingangsseite des Kühlventilators freiblasen und in den Zwischenraum zwischen Außenschrank und Innenschrank gelangerter Staub wieder absaugen und ins Freie zurückführen.

Zur Verbesserung des Spritzwasserschutzes kann nach einer weiteren Ausgestaltung vorgesehen sein, daß der Außenschrank einen Dachaufbau trägt, der Seitenwände, Rückwand und Schranktür desselben im Abstand teilweise überlappt.

Der Einbau des Innenschrankes in den Außenschrank erfolgt nach einer Ausgestaltung in der Weise, daß die Rückwand des Außenschrankes mit in dessen Innenraum ragenden Befestigungselementen und die Rückwand des Innenschrankes mit darauf abgestimmten Befestigungsaufnahmen versehen sind, wobei Befestigungselemente und Befestigungsaufnahmen staub- und spritzwasserdichte Verbindungen sicherstellen.

Der elektrische Anschluß des Gerätes wird so ausgeführt, daß die Anschlußkabel für die im Innenschrank untergebrachten Geräte mittels Kabeleinführungen staubund spritzwasserdicht durch den Innenschrank geführt sind.

Die Erfindung wird anhand eines in den Zeichnungen dargestellten Ausführungsbeispiels näher erläutert. Es zeigen:
- Fig. 1: in Vorderansicht bei geöffneter Schranktür einen Innenschrank mit eingebauten elektrischen und/oder elektronischen Bauteilen,
- Fig. 2: ein Ausführungsbeispiel für einen als getrennte Einheit einsetzbaren Luftwärmetauscher und
- Fig. 3: in Vorderansicht bei geöffneter Schranktür einen Außenschrank zum Einbau eines Innenschrankes nach Fig. 1, und
- Fig.4: in Vorderansicht den Gehäuseaufbau aus Innenschrank und Außenschrank bei geschlossenem, bestücktem Innenschrank und geöffnetem Außenschrank.

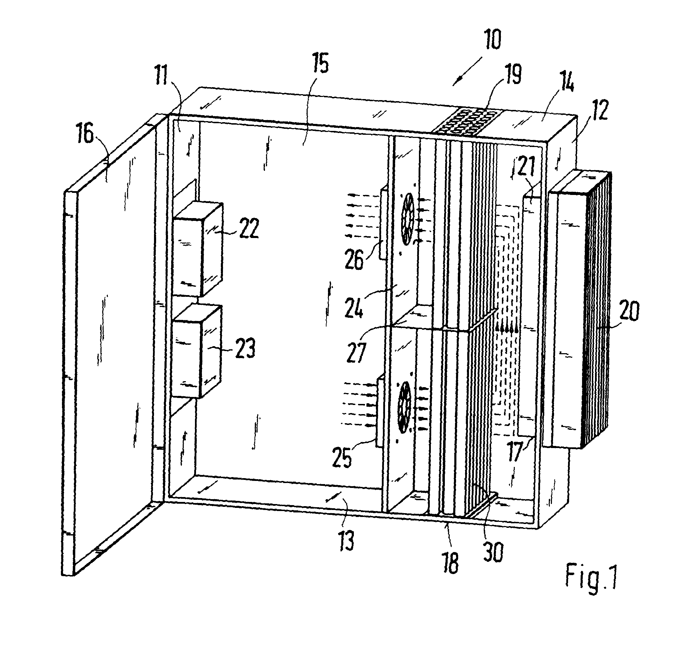

Wie Fig. 1 zeigt, werden in einen staub- und spritzwasserdicht (IP66) verschließbaren Schaltschrank als Innenschrank 10 die elektrischen und/oder elektronischen Bauteile 21, 22 und 23 eingebaut. So kann 21 als eine mit Wärme erzeugenden Halbleitern versehene Fernsehsende- oder Fernsehempfangseinrichtung ausgelegt sein, während die Bauteile 22 und 23 Netzgeräte sein können. Diese Bauteile sind an den Seitenwänden 11 und 12 des Innenschrankes 10 befestigt. Diese Seitenwände 11 und 12 haben Durchbrüceh 17, in denen auf den Außenseiten befestigte Kühlkörper 20 und 28 befestigt sind, so daß ihre Befestigungsflächen für die zu kühlenden Halbleiter vom Innenraum des Innenschrankes 10 aus zugänglich sind. Damit die in den Bauteilen 21, 22 und 23 auftretende Wärme sicher und möglichst vollständig an die Kühlkörper 20 und 28 abgegeben wird, sind die Bauteile 21, 22 und 23 zum Innenraum des Innenschrankes 10 hin wärmeisoliert.

Um die im Innenraum des Innenschrankes 10 auftretende Wärme - sei es durch Aufheizung von außen oder Restwärme der eingebauten Bauteile - abzuführen, ist im Innenraum des Innenschrankes 10 mit den Umwälzventilatoren 25 und 26 und einem Luftwärmetauscher 30 ein Umwälzkreis geschaffen. Der erste Umwälzventilator 25 saugt Luft an und führt sie dem der unteren Seitenwand 13 benachbarten Bereich des Luftwärmetauschers 30 zu, während der zweite Umwälzventilator 26 im oberen, der oberen Seitenwand 14 des Innenschrankes 10 zugekehrten Bereich des Luftwärmetauschers 30 die Luft wieder über denselben ansaugt und dem Innenraum wieder zuführt.

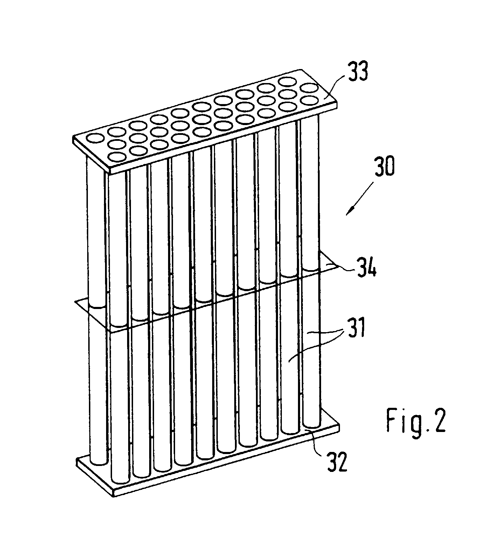

Wie Fig. 2 zeigt, kann als Luftwärmetauscher 30 ein Rohrbündel verwendet werden, bei dem die Enden der Rohre 31 in Halteplatten 32 und 33 festgelegt und der unter und obere Bereich der Rohre 31 durch ein Trennblech 34 abgeteilt sind. Diese Rohres 31 sind dünnwandig und bilden eingangsseitig mit ihren Außenoberflächen eine große Oberfläche als Eingangskreis, während die Innenoberflächen der Rohre 31 einen ebenso großflächigen Ausgangskreis bilden. Dieser Ausgangskreis ist von dem Eingangskreis staubdicht entkoppelt.

Ist der Luftwärmetauscher 30 als getrennte Einheit ausgebildet und hergestellt, dann kann er in den Innenschrank 10 eingesetzt werden, wobei die Eingangs- und Ausgangsöffnungen der Rohre 31 mit entsprechenden Öffnungen 18 und 19 in der unteren und oberen Seitenwand 19 des Innenschrankes 10 zur Deckung kommen.

Die Umwälzventilatoren 25 und 26 werden auf einer Trägerplatte 24 befestigt, die parallel zu den Rohren 31 des Luftwärmetauschers 30 in den Innenschrank 10 eingesetzt werden. Die Seitenwände 13 und 14 tragen auf ihren Innenseiten entsprechende Aufnahmen und Führungen zur Festlegung der Trägerplatte 24 und der Halteplatten 32 und 33 des Luftwärmetauschers 30. Ein Trennblech 27 auf der Trägerplatte 24 bildet mit dem Trennblech 34 des Luftwärmetauschers 30 auch im Bereich der Umwälzventilatoren 25 und 26 eine Abgrenzung beider Zweige der umgewälzten Luft.

Durch die Rohre 31 des Luftwärmetauschers 30 wird kühlende Luft geleitet, wie noch gezeigt wird.

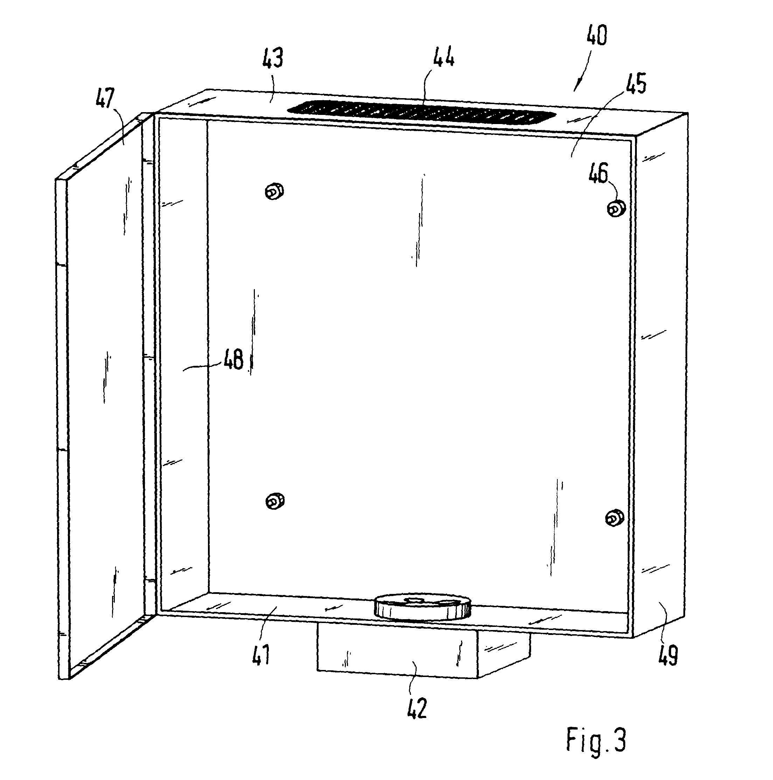

Der Innenschrank 10 nach Fig. 1 wird in einen spritzwassergeschützten Außenschrank 40 (IP44) nach Fig. 3 eingebaut. Dieser Außenschrank 40 wird auf der Rückwand 45 mit Befestigungselementen 46 versehen, während die Rückwand 15 des Innenschrankes 10 mit entsprechend verteilten und angepaßten Befestigungsaufnahmen für diese Befestigungselemente 46 versehen ist. Die Verbindungen sind dabei staub- und spritzwasserdicht und so ausgebildet, daß alle Seitenwände 11, 12, 13 und 14, die Rückwand 15 und die Schranktür 16 im Abstand zu den zugekehrten Seitenwänden 41, 43, 48 und 49, der Rückwand 45 und der Schranktür 47 des Außenschrankes 40 stehen. In die untere Seitenwand 41 des Außenschrankes 40 ist ein leistungsstarker staub- und spritzwassergeschützter Kühlluft-Ventilator 42 (IP66) eingebaut, der Luft aus dem Freien ansaugt und dem Innenraum des Außenschrankes 40 zuführt. In der oberen Seitenwand 43 des Außenschrankes 40 sind Austrittsöffnungen 44 für den Kühl-Luftstrom eingebracht.

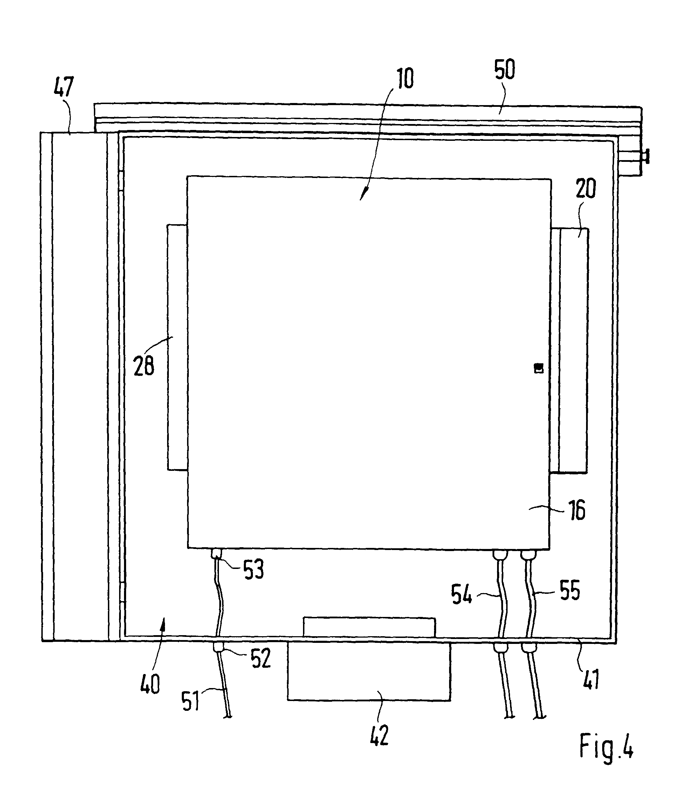

Wie Fig. 4 zu entnehmen ist, durchströmt der gesteuerte Kühl-Luftstrom von unten nach oben alle Seiten des in den Außenschrank 40 eingebauten Innenschrankes 10, wobei ein Teil die Rohre 31 des Luftwärmetauschers 30 durchströmt und für die Wärmeabfuhr aus dem Innenraum des Innenschrankes 10 sorgt. Der Kühl-Luftstrom ist auch über die auf der Außenseite des Innenschrankes 10 befestigten Kühlkörpers 20 und 28 geführt und verbessert so deren Kühlwirkung durch gute Wärmeabfuhr.

Die Anschlußkabel 51, 54 und 55 werden über staub- und spritzwasserdichte Kabeleinführungen 53 in den Innenschrank 10 hineingeführt und ebenso herausgeführt. Dabei können die Anschlußkabel 51 und 54 die Stromversorgung übernehmen, während das Anschlußkabel 55 als Antennenzuleitung dienen kann. Die Kabeleinführungen 52 in den Außenschrank 40 brauchen nur spritzwassergeschützt ausgeführt zu werden.

Auf dem Außenschrank 40 ist ein Dachaufbau 50 befestigt, der die Seitenwände 48 und 49, die Rückwand 45 und die Schranktür 47 im Abstand teilweise überlappt und so einen eindeutigen Regenschutz für die oberen horizontalen Kanten des Außenschrankes 40 bringt.

Die Eingangsseite des Kühlluft-Ventilators 42 ist mit einem Schutzgitter abgedeckt, an dem größere Fremdkörper, wie Laub oder dgl., zurückgehalten werden. Damit ein ungewollter Verschluß des Schutzgitters verhindert wird, wird in Zeitabständen oder in Abhängigkeit vom Auftreten eines Temperaturanstieges im Innenraum des Innen- und/oder Außenschrankes die Drehrichtung des Kühlluft-Ventilators 42 kurzzeitig umgeschaltet, so daß der Luftstrom seine Richtung umkehrt. Auf diese Weise läßt sich das Schutzgitter des Kühlluft-Ventilators 42 abblasen und evtl. in den Außenschrank 40 gelangter Staub absaugen und wieder ins Freie zurückführen.

Der Außenschrank 40 verhindert eine Aufheizung des Innenschrankes 10 durch Sonneneinstrahlung.

Der in den Boden 41 des Außenschrankes 40 eingebaute Kühlluft-Ventilator 42 ist vorzugsweise dauernd eingeschaltet, damit seine Lager nicht festsitzen können.

Wird der Gehäuseaufbau in Gebieten eingesetzt, in denen tiefe Temperaturen auftreten können, dann wird in den Innenschrank 10 ein Heizgerät eingebaut. Dieses Heizgerät wird bei Erreichen einer bestimmten Minustemperatur eingeschaltet und beim Aufwärmen auf eine vorgegebene höhere Temperatur wieder abgeschaltet.

## Patentansprüche

1. Gehäuseaufbau für im Freien aufstellbare elektrische und/oder elektronische Geräte,
dadurch gekennzeichnet,
daß die elektrischen und/oder elektronischen Bauteile (21,22, 23) des Gerätes in einem staub- und spritzwasserdicht verschließbaren Innenschrank (10) untergebracht sind, der vorzugsweise allseitig beabstandet in einen spritzwasserdicht verschließbaren Außenschrank (40) eingebaut ist,
daß im Innenschrank (10) ein Luftwärmetauscher (30) eingesetzt ist, dessen Eingangskreis über Umwälz-Ventilatoren (25,26) die im Innenschrank (10) auftretende Warmluft zuführbar ist und dessen Ausgangskreis mit dem Innenraum des Außenschrankes (40) gekoppelt ist, und
daß der Außenschrank (40) zur Kühlung des Innenschrankes (10) von einem gesteuerten Kühl-Luftstrom durchströmt ist, von dem ein Teil den Ausgangskreis des Luftwärmetauschers (30) passiert.

2. Gehäuseaufbau nach Anspruch 1,
dadurch gekennzeichnet,
daß der Luftwärmetauscher (30) als Rohrbündel ausgebildet ist, bei dem die Rohreingänge und -ausgänge mit korrespondierenden Öffnungen (18,19) in der unteren und oberen Seitenwand (13,14) des Innenschrankes (10) zur Deckung gebracht oder bringbar sind.

3. Gehäuseaufbau nach Anspruch 1 oder 2,
dadurch gekennzeichnet,
daß der Luftwärmetauscher (30) als getrennte Einheit in den Innenschrank (10) einsetzbar ist.

4. Gehäuseaufbau nach Anspruch 2 oder 3,
dadurch gekennzeichnet,
daß dem Luftwärmetauscher (30) in dem der unteren Seitenwand (13) zugekehrten Bereich mittels eines ersten Umwälzventilators (25) die Warmluft des Innenschrankes (10) zuführbar und mittels eines zweiten Umwälzventilators (26) in dem der oberen Seitenwand (14) des Innenschrankes (10) zugekehrten Bereich wieder aus dem Luftwärmetauscher (30) absaugbar ist.

5. Gehäuseaufbau nach Anspruch 4,
dadurch gekennzeichnet,
daß der untere und der obere Bereich des Luftwärmetauschers (30) durch ein Trennblech (27) abgeteilt sind.

6. Gehäuseaufbau nach Anspruch 4 oder 5,
dadurch gekennzeichnet,
daß die Umwälzventilatoren (25,26) auf einer Trägerplatte (24) befestigt sind, die parallel zum Luftwärmetauscher (30) in den Innenschrank (10) einsetzbar ist.

7. Gehäuseaufbau nach einem der Ansprüche 1 bis 6,
dadurch gekennzeichnet,
daß bei auf Kühlkörpern (20,28) oder dgl. aufgebauten, elektronischen Bauteilen (21) die Kühlkörper (20,28) auf der Außenseite der Seitenwände (11,12) des Innenschrankes (10) befestigt sind und über Durchbrüche (17) mit dem Innenraum des Innenschrankes (10) in Verbindung stehen.

8. Gehäuseaufbau nach Anspruch 7,
dadurch gekennzeichnet,
daß die im Innenraum des Innenschrankes (10) mit den Kühlkörpern (20,28) oder dgl. in Kontakt stehenden, elektronischen Bauteile (21) zum Innenraum des Innenschrankes (10) hin mittels einer wärmeisolierenden Abdeckung abgedeckt sind.

9. Gehäuseaufbau nach einem der Ansprüche 1 bis 8,
dadurch gekennzeichnet,
daß die Außen- und Innenoberflächen vom Innenschrank (10) mit einem Belag oder Anstrich versehen sind, der gute Wärmeabgabeeigenschaften aufweist, z.B. schwarz gestrichen ist.

10. Gehäuseaufbau nach einem der Ansprüche 1 bis 9,
dadurch gekennzeichnet,
daß der Kühl-Luftstrom von einem in die untere Seitenwand (41) des Außenschrankes (40) eingebauten staub- und spritzwassergeschützten Kühlluft-Ventilator (42) (IP66) erzeugt wird, der die Luft aus dem Freien ansaugt und dem Innenraum des Außenschrankes (40) zuführt, und daß der erwärmte Kühl-Luftstrom über Austrittsöffnungen (44) in der oberen Seitenwand (43) aus dem Außenschrank (40) austritt.

11. Gehäuseaufbau nach Anspruch 10,
dadurch gekennzeichnet,
daß der Kühlluft-Ventilator (42) zeitabhängig oder temperaturabhängig in der Drehrichtung kurzzeitig umschaltbar ist und den Luftstrom durch den Außenschrank (40) umkehrt (Reservebetrieb).

12. Gehäuseaufbau nach einem der Ansprüche 1 bis 11,
dadurch gekennzeichnet,
daß der Außenschrank (40) einen Dachaufbau (50) trägt, der Seitenwände (48,49), Rückwand (45) und Schranktür (47) desselben im Abstand teilweise überlappt.

13. Gehäuseaufbau nach einem der Ansprüche 1 bis 12,
dadurch gekennzeichnet,
daß die Rückwand (45) des Außenschrankes (40) mit in dessen Innenraum ragenden Befestigungselementen (46) und die Rückwand (15) des Innenschrankes (10) mit darauf abgestimmten Befestigungsaufnahmen versehen sind, wobei Befestigungselemente (46) und Befestigungsaufnahmen staub- und spritzwasserdichte Verbindungen sicherstellen.

14. Gehäuseaufbau nach einem der Ansprüche 1 bis 13,
dadurch gekennzeichnet,
daß die Anschlußkabel (51) für die im Innenschrank (10) untergebrachten Geräte mittels Kabeleinführungen (53) staub- und spritzwasserdicht in den Innenschrank (10) geführt sind.

15. Gehäuseaufbau nach einem der Ansprüche 1 bis 14,
dadurch gekennzeichnet,
daß in den Innenschrank (10) ein Heizgerät eingebaut ist, das beim Erreichen einer vorgegebenen Minustemperatur einschaltbar und beim Wiedererreichen einer vorgegebenen Temperaturerhöhung abschaltbarist.

16. Gehäuseaufbau nach einem der Ansprüche 1 bis 15,
dadurch gekennzeichnet,
daß der Kühlluft-Ventilator (42) dauernd eingeschaltet ist oder in den Einschaltphasen mit voller Drehzahl betrieben wird.

## Claims

1. Housing structure for electrical and/or electronic devices, which are installable outdoors, characterised in that the electrical and/or electronic components (21,22,23) of the device are accommodated in an inner cabinet (10), which is closable in a dustproof and splashproof manner, said cabinet being incorporated in an outer cabinet (40), which is closable in a splashproof manner and is preferably spaced frcm said inner cabinet in all directions, in that an air heat exchanger (30) is inserted in the inner cabinet (10), the heated air created in the inner cabinet (10) being suppliable to the input circuit of said exchanger via circulating fans (25,26), and the output circuit of said exchanger being connected to the interior of the outer cabinet (40), and in that, in order to cool the inner cabinet (10), the outer cabinet (40) is traversed by a controlled cooling air flow of cooling air, a portion of which passes the output circuit of the heated-air exchanger (30).

2. Housing structure according to claim 1, characterised in that the heated-air exchanger (30) is configured as a group of tubes, wherein the tube inlets and outlets are brought or can be brought to coincide with corresponding apertures (18,19) in the lower and upper lateral wails (13,14) of the inner cabinet (10).

3. Housing structure according to claim 1 or 2, characterised in that the heated-air exchanger (30) is insertable as a separate unit in the inner cabinet (10).

4. Housing structure according to claim 2 or 3, characterised in that the heated air of the inner cabinet (10) is suppliable to the heated-air exchanger (30) in the region facing the lower lateral wall (13) by means of a first circulating fan (25) and is extractable again from the heated-air exchanger (30) by means of a second circulating fan (26) in the region facing the upper lateral wall (14) of the inner cabinet (10).

5. Housing structure according to claim 4, characterised in that the lower and upper regions of the heated-air exchanger (30) are divided by a dividing plate (27).

6. Housing structure according to claim 4 or 5, characterised in that the circulating fans (25,26) are mounted on a carrier plate (24), which is insertable in the inner cabinet (10) parallel to the heated-air exchanger (30).

7. Housing structure according to one of claims 1 to 6, characterised in that, when electronic components (21) are constructed on heat sinks (20,28), the heat sinks (20,28) are mounted on the outside of the lateral walls (11,12) of the inner cabinet (10) and communicate with the interior of the inner cabinet (10) via openings (17).

8. Housing structure according to claim 7, characterised in that the electronic components (21), which are in contact with the heat sinks (20,28) or the like in the interior of the inner cabinet (10), are covered by means of a heat-insulating cover towards the interior of the inner cabinet (10).

9. Housing structure according to one of claims 1 to 8, characterised in that the outer and inner surfaces of the inner cabinet (10) are provided with a covering or coating which has good heat-emitting properties, e.g. is coated black.

10. Housing structure according to one of claims 1 to 9, characterised in that the cooling air flow is generated by a dustproof and splashproof cooling air fan (42) (IP66), which is incorporated in the lower lateral wall (41) of the outer cabinet (40), said fan drawing-in the air from the atmosphere and supplying it to the interior of the outer cabinet (40), and in that the heated cooling air flow emerges from the outer cabinet (40) via outlet apertures (44) in the upper lateral wall (43).

11. Housing structure according to claim 10, characterised in that the cooling air fan (42) is briefly switchable in the direction of rotation in a time-dependent or temperature-dependent manner and reverses the flow of air through the outer cabinet (40) (reserve operation).

12. Housing structure according to one of claims 1 to 11, characterised in that the outer cabinet (40) is provided with a roof structure (50), which partially overlaps lateral walls (48,49), rear wall (45) and cabinet door (47) of said cabinet at a spacing therefrom.

13. Housing structure according to one of claims 1 to 12, characterised in that the rear wall (45) of the outer cabinet (40) is provided with securing members (46), which protrude into the interior of said cabinet, and the rear wall (15) of the inner cabinet (10) is provided with securing receivers, which are adapted thereto, securing members (46) and securing receivers ensuring dustproof and splashproof connections.

14. Housing structure according to one of claims 1 to 13, characterised in that the connecting cables (51) for the devices accommodated in the inner cabinet (10) are guided into the inner cabinet (10) in a dustproof and splashproof manner by means of cable inlets (53).

15. Housing structure according to one of claims 1 to 14, characterised in that a heating device is incorporated in the inner cabinet (10), said device being capable of being switched-on when a prescribed negative temperature is reached and being capable of being switched-off when a prescribed temperature increase is regained.

16. Housing structure according to one of claims 1 to 15, characterised in that the cooling air fan (42) is permanently switched-on or is operated at full speed in the switched-on phases.

## Revendications

1. Structure de boîtier pour dispositifs électriques et/ou électroniques à installer en plein air,
caractérisée
en ce que les composants électriques et/ou électroniques (21, 22, 23) du dispositif sont logés dans une armoire intérieure (10) fermée à l'abri de la poussière et des projections d'eau, armoire qui est montée de préférence avec ses parois éloignées de toutes parts à l'intérieur d'une armoire extérieure (40) pouvant être fermée hermétiquement à l'abri des projections d'eau,
en ce que dans l'armoire intérieure (10) est disposée un échangeur de chaleur à air (30), au circuit d'entrée duquel peut être alimenté par l'intermédiaire de ventillateurs de circulation (25, 26) l'air chaud engendrée dans l'armoire intérieure (40) et dont le circuit de sortie est couplé à l'enceinte intérieure de l'armoire extérieure (40), et
en ce que qu'aux fins du refroidissement de l'armoire intérieure (10), l'armoire extérieure (40) est parcourue par un courant d'air de refroidissement, dont une partie passe par le circuit de sortie de l'échangeur de chaleur à air (30).

2. Structure de boîtier suivant la revendication 1,
caractérisée
en ce que l'échangeur de chaleur à air (30) a la forme d'un faisceau de tubes, dans lequel les entrées et sorties de tube sont mises en connexion ou peuvent être mises en connexion avec des ouvertures correspondantes (18, 19) dans la paroi latérale inférieure ou supérieure (13, 14) de l'armoire intérieure (10).

3. Structure de boîtier suivant la revendication 1 ou 2,
caractérisée en ce que l'échangeur de chaleur à air (30) peut être monté sous forme l'unité séparée dans l'armoire intérieure (10).

4. Structure de boîtier suivant la revendication 2 ou 3,
caractérisée en ce qu'à l'échangeur de chaleur à air (30) peut être alimenté dans la zone tournée vers la paroi latérale inférieure (13), au moyen d'un premier ventilateur de circulation (25) l'air chaud de l'armoire intérieure (10) et en ce que dans la zone tournée vers la paroi latérale supérieure (14) de l'armoire intérieure, cet air chaud peut, au moyen d'un second ventilateur de circulation (26), être aspiré de l'échangeur de chaleur à air (30).

5. Structure de boîtier suivant la revendication 4,
caractérisée
en ce que la zone inférieure et la zone supérieure de l'échangeur de chaleur à air (30) sont séparées par une tôle de séparation (27).

6. Structure de boîtier suivant la revendication 4 ou 5,
caractérisée
en ce que les ventilateurs de circulation (25, 26) sont fixés sur une plaque de support (24) qui peut être montée parallèlement à l'échangeur de chaleur à air (30) dans l'armoire intérieure (10).

7. Structure de boîtier suivant l'une quelconque des revendications de 1 à 6,
caractérisée
en ce que dans le cas où des composants électroniques (21) sont montés sur des corps de refroidissement (20, 28) ou similaires, les corps de refroidissement (20, 28) sont fixés sur la face extérieure des parois latérales (11, 12) de l'armoire intérieure (10) et sont par l'intermédiaire de passages (17) en communication avec l'enceinte intérieure de l'armoire intérieure (10).

8. Structure de boîtier suivant la revendication 7,
caractérisée
en ce que les composants électroniques (21) qui dans l'enceinte intérieure de l'armoire intérieure (10) sont en contact avec les corps de refroidissement (20, 28) ou similaires sont, en direction de l'armoire intérieure (10) recouverts au moyen d'un recouvrement isolant thermique.

9. Structure de boîtier suivant l'une quelconque des revendications de 1 à 8,
caractérisée
en ce que les surfaces extérieures et intérieures de l'armoire intérieure (10) sont dotées d'un revêtement ou d'un enduit qui présente de bonnes caractéristiques d'isolement thermique, et qui est par exemple de couleur noire.

10. Structure de boîtier suivant l'une quelconque des revendications de 1 à 9,
caractérisée
en ce que le courant d'air de refroidissement est engendré par un ventilateur d'air de refroidissement (42) du type IP66 protégé contre les poussières et les projections d'eau, monté dans la paroi latérale inférieure (41) de l'armoire extérieure (40), ventilateur qui aspire l'air extérieur et qui l'alimente à l'enceinte intérieure de l'armoire extérieure (40), et
en ce que le courant d'air réchauffé s'échappe de l'armoire extérieure (40) au travers des orifices d'échappement d'air (44) dans la paroi latérale supérieure (43).

11. Structure de boîtier suivant la revendication 10,
caractérisée
en ce que le sens de rotation du ventilateur d'air de refroidissement (42) peut être commuté instantanément en fonction d'un intervalle de temps ou de la température, et en ce que le courant d'air dans l'armoire extérieure (40) est inversé (service de réserve).

12. Structure de boîtier suivant l'une quelconque des revendications de 1 à 11,
caractérisée
en ce que l'armoire extérieure (40) porte une structure de toit (50), qui chevauche partiellement les parois latérales (48, 49), la paroi arrière (45) et la porte d'armoire (47) de l'armoire extérieure (40).

13. Structure de boîtier suivant l'une quelconque des revendications de 1 à 12,
caractérisée
en ce que la paroi arrière (45) de l'armoire extérieure (40) est dotée d'éléments de fixation (46) pénétrant dans l'enceinte intérieure de l'armoire extérieure (40) et en ce que la paroi arrière (15) de l'armoire intérieure (10) est dotée de récepteurs de fixation correspondants, et en ce que les éléments de fixation (46) et les récepteurs de fixation assurent des liaisons à l'abri de la poussière et des projections d'eau.

14. Structure de boîtier suivant l'une quelconque des revendications de 1 à 13,
caractérisée
en ce que les câbles de connexion (51) pour les appareils logés dans l'armoire intérieure (10) passent dans l'armoire intérieure (10) par des entrées de câble (53) assurant la protection contre les poussières et les projections d'eau.

15. Structure de boîtier suivant l'une quelconque des revendications de 1 à 14,
caractérisée
en ce que dans l'armoire intérieure (10) est monté un appareil de chauffage, qui peut être mis en marche lorsqu'une température de consigne minimale est atteinte et qui peut être mis à l'arrêt lorsqu'une augmentation de température de consigne est de nouveau atteinte.

16. Structure de boîtier suivant l'une quelconque des revendications de 1 à 15,
caractérisée
en ce que le ventilateur d'air de refroidissement (42) fonctionne en permanence ou tourne à la vitesse maximale lors de ses phases de fonctionnement.
